## Europäisches Patentamt
## European Patent Office
## Office européen des brevets

(11) Publication number: **0 011 405**
A1

# EUROPEAN PATENT APPLICATION

(21) Application number: **79302334.2**

(22) Date of filing: **25.10.79**

(51) Int. Cl.³: **G 11 C 11/40**
**H 01 L 27/06, G 11 C 11/34**

(30) Priority: **30.10.78 JP 133386 78**

(43) Date of publication of application:
**28.05.80 Bulletin 80 11**

(84) Designated Contracting States:
**DE FR GB NL**

(71) Applicant: **FUJITSU LIMITED**
**1015, Kamikodanaka Nakahara-ku**
**Kawasaki-shi Kanagawa 211(JP)**

(72) Inventor: **Toyoda, Kazuhiro**
**39, Sakuradai Midori-ku**
**Yokohama-shi Kanagawa 227(JP)**

(74) Representative: **Abbott, Leonard Charles et al,**
**GILL JENNINGS & EVERY 53 64 Chancery Lane**
**London WC2A 1HN(GB)**

(54) Semiconductor memory.

(57) A semiconductor memory is formed of a plurality of memory cells, which are connected to different points along first and second word lines. To prevent differences in the amplitudes of the hold currents in the different memory cells due to word line resistance, according to the present invention the areas of emitters ($E_l$, $E_m$) of the transistors by which the hold current of the memory cells ($CEL_l$, $CEL_m$) are determined are varied according to the cell position along the word lines.

./...

Fig. 5

## SEMICONDUCTOR MEMORY

The present invention relates to a semiconductor memory formed by a plurality of memory cells each of which is connected to a first word line and a second word line.

In such a semiconductor memory array, the hold currents are supplied from the word lines to the memory cells. The word lines have an electric resistance; therefore, the hold currents which are supplied to the memory cells differ from cell to cell due to the potential drop caused in the word lines so that the noise immunity of the semiconductor memory decreases. This drawback is particularly apparent when the word lines are formed of a material having a high electric resistance, such as a poly-silicon. Further, even if the word lines are formed by a metal, such as an aluminium, when the memory is formed as a fine construction by a high integration technique, the above-mentioned drawback is magnified due to parasitic resistance in the word lines.

The decrease of the noise immunity due to the nonuniform distribution of the hold current can be overcome by increasing the minimum hold current, so as to improve the noise immunity in the memory cell having the miminum hold current. However, when the minimum hold current increases, the hold currents in the other cells also increase, and therefore, the electric power dissipation in the whole memory increases.

A semiconductor memory according to the present invention, having a plurality of memory cells which are connected to different points along common word lines having electrical resistance, each memory cell including a pair of transistors for supplying a hold current, is characterised in that the memory cells have respective transistor emitter regions of different areas such that the hold currents of the different memory cells are substantially uniform regardless of the positions of the memory cells along the word lines. In this way, we prevent the noise immunity of the memory apparatus from decreasing due to the electrical resistance of the word lines.

Further features and advantages of the present invention will be apparent from the ensuing description, with reference to the accompanying drawings, of examples of semiconductor memories embodying the invention. In the drawings:

Figure 1 illustrates one example of the circuit of a conventional semiconductor memory;

Figure 2 is a diagram showing a distribution of hold currents in the circuit shown in Figure 1;

Figure 3 illustrates the circuit of another conventional semiconductor memory apparatus;

Figure 4 is a diagram showing a distribution of the hold currents in the circuit shown in Figure 3;

Figure 5 is a plan view of patterns of one embodiment of a semiconductor memory according to the present invention;

Figure 6 is a diagram showing a relation between the emitter area and the memory cell position in the semiconductor memory shown in Figure 5;

Figures 7A, 7B and 7C illustrate another embodiment of the semiconductor memory according to the present invention;

Figure 8 is a diagram showing the relations of the emitter area and the memory cell position in the semiconductor memory shown in Figure 7A ;

Figure 9 is an equivalent circuit of the semiconductor memory which is used for determining the areas of the emitter according to the present invention;

Figure 10 is a diagram showing a voltage distribution in the equivalent circuit shown in Figure 9; and,

Figures 11 A and 11B are equivalent circuits of the memory cell which are used for determining the hold current in the present invention.

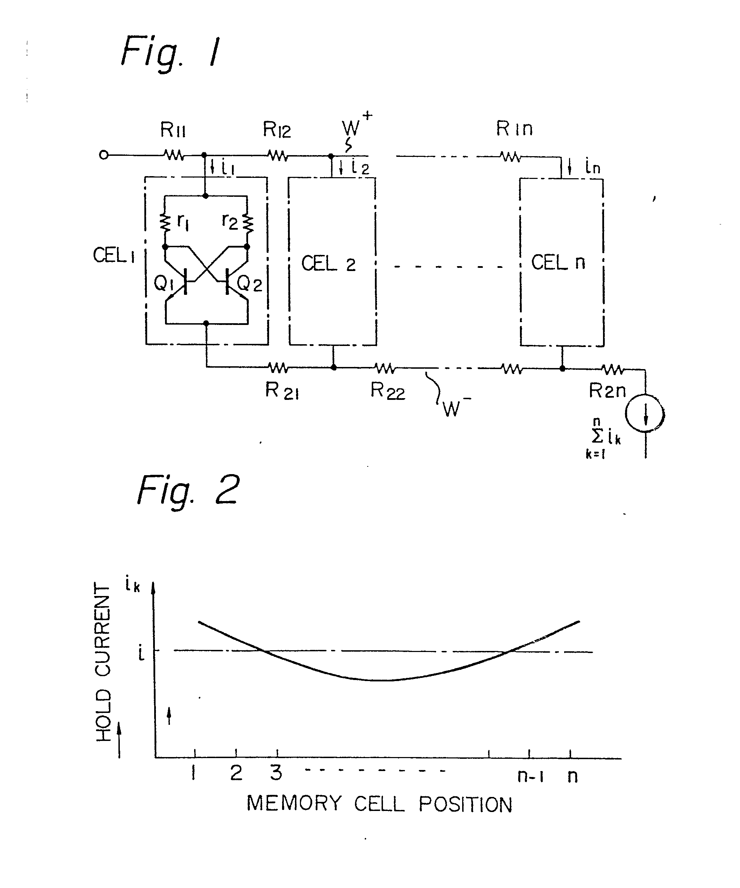

Referring to Figure 1, the semiconductor memory is formed by cells $CEL_1$ to $CEL_n$ and each cell is connected to a word line W+ and to a word line W-. Hold currents $i_1$, $i_2$, ..., $i_n$ are supplied to the cells $CEL_1$ to $CEL_n$. Each memory cell is formed by a first resistor $r_1$ and second resistor $r_2$ , one end of each of which is connected to a first word line W+, and a first transistor $Q_1$ and a second transistor $Q_2$, the collectors of which are respectively connected to the other ends of the first resistor $r_1$ and second resistor $r_2$. The emitters of the first transistor $Q_1$ and second transistor $Q_2$ are connected to a common second word line W-. The base of the first transistor $Q_1$ is connected to the collector of the second transistor $Q_2$ and the base of the second transistor $Q_2$ is connected to the collector of the first transistor $Q_1$.

In the semiconductor memory apparatus shown in Figure 1 the values of the hold currents $i_1$, $i_2$, ..., $i_n$ vary with the position of the memory cell along the word lines in the manner shown in Figure 2, due to the voltage drops caused in resistances $R_{11}$ to $R_{1n}$ and $R_{21}$ to $R_{2n}$ in the word lines. As shown in Figure 2, the hold currents which are supplied to the memory cells positioned at a middle part of the array are smaller than a mean hold current value of

$$i = \frac{1}{n} \sum_{k=1}^{n} i_k;$$

therefore, the noise immunity is considerably decreased and a malfunction is easily caused.

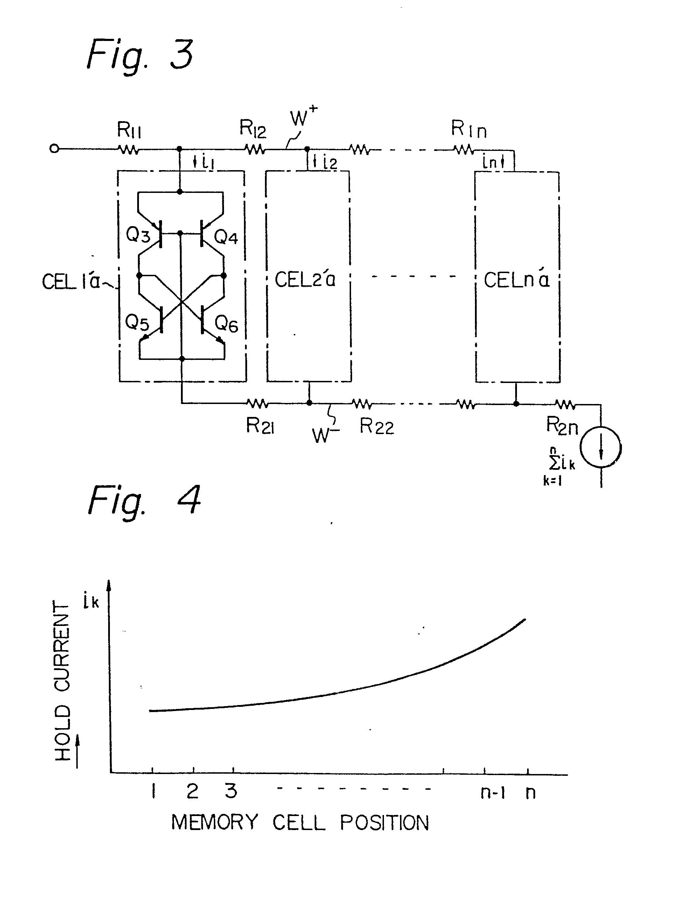

A semiconductor memory apparatus shown in Figure 3 is formed by cells $CEL_{1a}$, $CEL_{2a}$, ..., $CEL_{na}$, each connected to the word lines W+ and W-, and having respective hold currents $i_1$ to $i_n$. Each cell is formed by integrated injection logic and includes first and second transistors $Q_3$, $Q_4$, of a first conduction type which have a common emitter forming an injector connected to a first word line W+, and third and fourth transistors $Q_5$, $Q_6$ of a second conduction type, the collectors of which are connected to the collectors of transistors $Q_3$ and $Q_4$, respectively. The base of the transistor $Q_5$ is connected to the collector of the transistor $Q_6$, and the base of the transistor $Q_6$ is connected to the collector of the transistor $Q_5$. The bases of transistors $Q_3$ and $Q_4$ are connected to the emitters of the transistors $Q_5$, $Q_6$ and to a second word line W-. In the apparatus shown in Figure 3, the hold currents $i_1$, $i_2$, ..., $i_n$, are supplied to the memory cells $CEL_{1a}$ to $CEL_{na}$ from the word line W+ having parasitic resistances $R_{11}$ to $R_{1n}$, and the word line W- has parasitic resistances $R_{21}$ to $R_{2n}$. In the apparatus formed by the integrated injection type memory cells, the word line W- is formed by a buried diffusion layer. Therefore, the parasitic resistances $R_{21}$ to $R_{2n}$ are larger than the parasitic resistances $R_{11}$ to $R_{1n}$. Accordingly, the values of the hold currents $i_1$, $i_2$, ..., $i_n$, are distributed as shown in Figure 4 in accordance with the memory cell position, and the hold currents supplied to the memory cells at the right side are larger than the hold currents supplied to the memory cells at the left side.

In a semiconductor memory embodying the present invention, the hold currents for memory cells in different

positiqns relative to the word lines are equalised by selecting the area of the emitter of the transistor by which the hold current of the memory cell is determined.

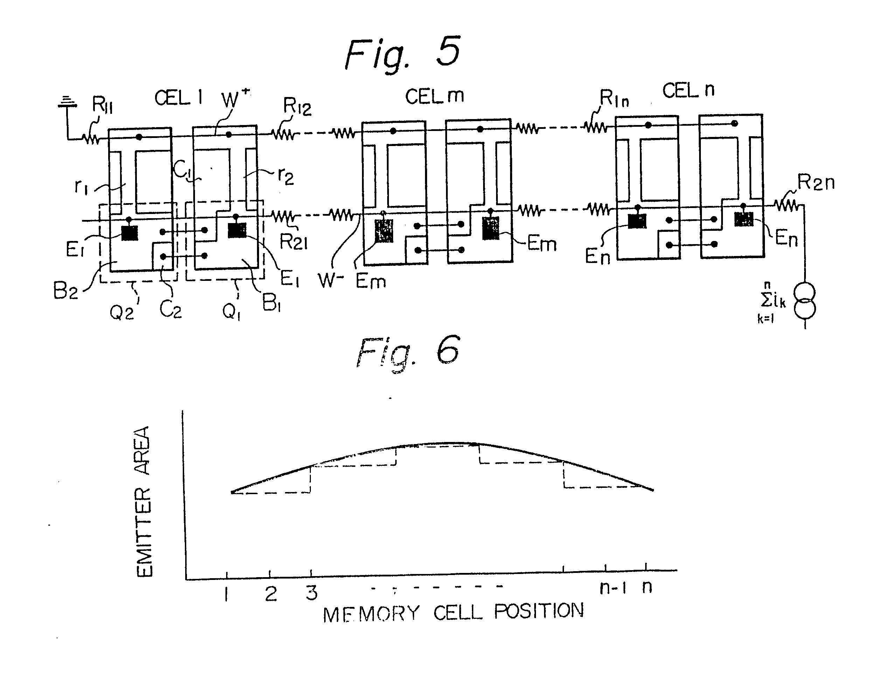

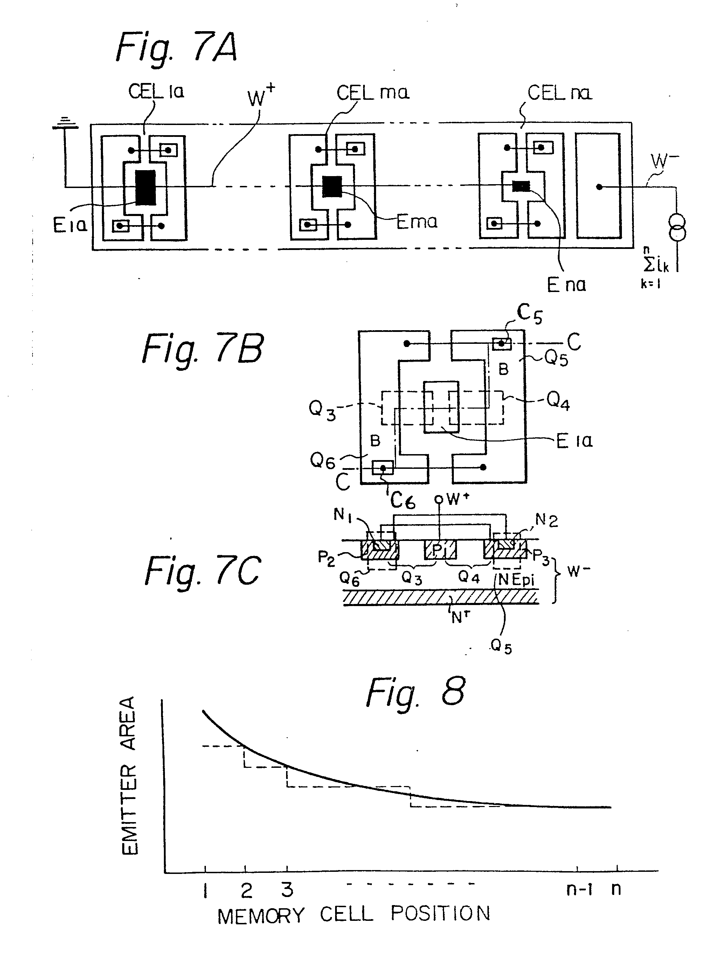

Figure 5 is a plan view of patterns of a first embodiment of the integrated memory embodying the present invention. The memory shown in Figure 5 corresponds to the circuit shown in Figure 1 , and the same symbols are for corresponding portions of the memory. Also, $B_1$, $B_2$ and $C_1$, $C_2$ denote the bases and collectors of transistors in the memory cell $CEL_1$. For the memory shown in Figure 5, the characteristic feature of the present invention is that the area of the emitter $E_m$ of the transistor included in the cell which is positioned in the middle portion of the array is larger than the areas of the emitters of those transistors included in cells which are positioned at the end portions of the array. This is illustrated in Figure 6, which shows the relation between the emitter area and the memory cell position. Further, the emitter area can be changed continuously from the position 1 to the position n as shown by the solid line in Figure 6; and also the emitter area can be changed from group to group from the position 1 to the position n as shown by the dotted line in Figure 6, each such group including two or more memory cells.

Figures 7A, 7B and 7C show a second embodiment of the integrated memory according to the present invention. The memory shown in Figure 7A corresponds to the circuit shown in Figure 3, and the same symbols are used for corresponding portions of the two Figures. Referring to Figures 7A, 7B and 7C, Figure 7A is a plan view of a pattern of the memory and corresponds to Figure 3, Figure 7B is a plan view of a detailed construction of $CEL_{1a}$ and Figure 7C is a cross-section along C-C of $CEL_{1a}$ shown in Figure 7B. In Figure 7C, an epitaxial layer $NE_{pi}$ is formed on the semiconductor substrate via a buried layer N+; p-type impurity regions $P_1$, $P_2$, $P_3$ are formed in the epitaxial layer $NP_{pi}$, n-type impurity regions are formed in the P-type impurity regions $P_1$ and $P_3$. The transistor $Q_3$ is formed by regions $P_1$, $NE_{pi}$ and $P_2$, the transistor $Q_4$ is formed by regions $P_1$, $NE_{pi}$ and $P_3$, the transistor $Q_6$ is formed by regions $N_1$, $P_2$ and $NE_{pi}$, and the transistor $Q_5$ is formed by regions $N_2$, $P_3$ and $NE_{pi}$. Further, the region $P_1$ is connected to the word line W+ and the region $NE_{pi}$ with the buried layer N+ forms the word line W-.

For the hold currents supplied to the cells $CEL_{1a}$ to $CEL_{na}$ to be uniformly distributed, the areas of the transistor emitters used as injectors vary with cell position in the manner illustrated in Figure 8. In the apparatus shown in Figure 7A, the emitter area can be changed continuously from the position 1 to the position n as shown by the solid line in Figure 8. Alternatively, the emitter area can be changed by group, each group including a plurality of the memory cells as shown in dotted line in Figure 8.

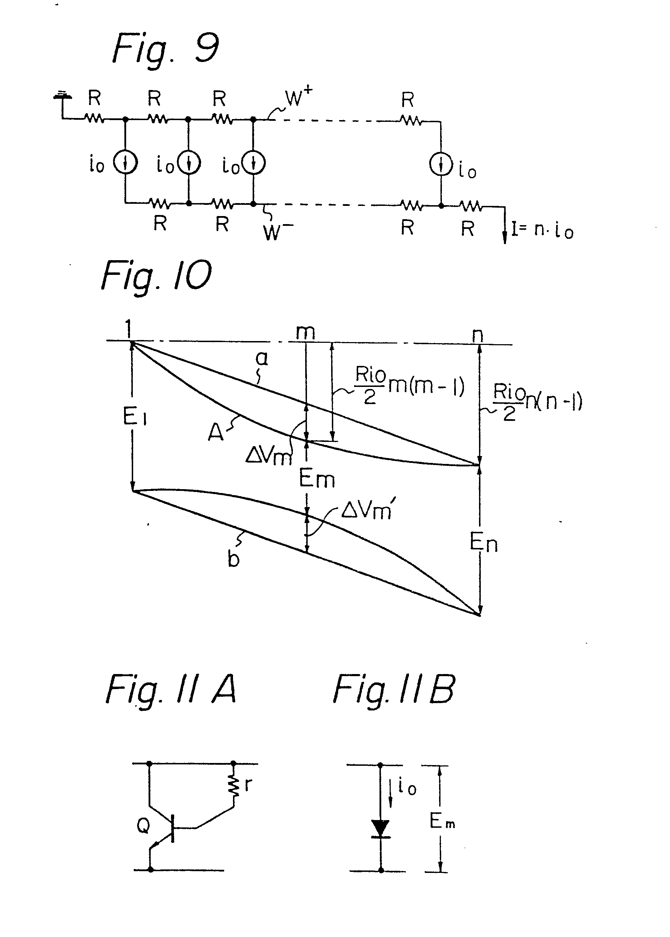

Next, we will explain the condition for uniformly distributing the constant hold currents to the memory cells. In Figure 9, we assume that parasitic resistance in the word line is R and the constant hold current supplie to the memory cells is $i_0$. The voltage drop caused in the upper word line W+ is illustrated by a curve A shown in Figure 10. In the curve A in Figure 10, the voltage deviation $\Delta V_m$ with respect to the straight line $\underline{a}$ in the memory cell m is expressed as shown below:

$$\Delta V_m = \frac{R \cdot i_0}{2} \quad (n - m)(m - 1) \qquad (1)$$

The voltage drop caused in the lower word line W- is similarly illustrated by a curve B shown in Figure 10, and the voltage deviation $\Delta V'_m$ with respect to the straight line b in the memory cell is expressed as shown below:

$$\Delta V'_m = \frac{R \cdot i_0}{2} (n - m)(m - 1) \qquad (2)$$

Therefore, the value of the voltage $E_m$ applied to the memory cell $CEL_m$ is smaller than the voltage $E_1$ and $E_n$ applied to the memory cells $CEL_1$ and $CEL_n$. The difference between the voltage $E_m$ and $E_1$ , $E_n$ is shown below:

$$\Delta V_m + \Delta V'_m = R \cdot i_0 \ (n - m) \ (m - 1) \quad (3)$$

The construction of the memory cell portion which has a relation to the hold current of the memory cell can be illustrated by a transistor Q and a resistor r shown in Fig. 11A and the voltage current characteristic of the memory cell can be illustrated by a diode as shown in Fig. 11B. Therefore, with respect to the memory cell $CEL_m$, the current $i_0$ is supplied by applying the voltage $E_m$. The voltage $E_m$ is expressed as shown below:

$$E_m = \frac{k \cdot T}{q} \log \frac{i_0}{A_m J_s} \quad (4)$$

In the equation (4) above, q is an electric charge of the electron, k is Boltzman's constant, T is an absolute temperature, $A_m$ is the emitter area, and $J_s$ is a saturation current per unit area of the emitter junction. The voltage $E_m$ is also expressed as

$$E_m = E_1 - R \cdot i_0 \ (n - m) \ (m - 1) \quad (5)$$

The emitter area of the memory cell in each position can be determined by the voltage $E_1$ which is applied to the memory cell positioned at both terminals of the memory cell array and the number of the cell position m.

With respect to the hold currents supplied to the memory cell array having the characteristics shown in Fig. 4, a similar calculation as carried out with respect to Figs. 9 and 10 can be applied, and emitter areas which are changed from the position 1 to the position n can be obtained.

As mentioned above, according to the present invention, the emitter areas of the transistors ($Q_1$ , $Q_2$ in Fig. 1 and $Q_3$ , $Q_4$ in Fig. 3) by which the hold current of the memory cell are determined are changed so that the deviation of the applied voltage to the memory cell due to the parasitic resistance in the word line is compensated. The emitter areas can be changed in each memory cell or in each memory cell group, so that the hold currents can be uniformly supplied to the memory cells, the noise immunity in each memory cell can be equalized and the effect of the parasitic resistance in the word line can be removed. Therefore, the operation of each memory cell having a high density can be stabilized. As the emitter areas can be obtained by taking into consideration of the material and the dimension of the word line, the manufacturing process can be easily carried out and a semiconductor memory apparatus having a predetermined noise immunity can be easily obtained.

# C L A I M S

1. A semiconductor memory having a plurality of memory cells (CEL) which are connected to different points along common word lines (W+, W-) having electrical resistance, each memory cell including a pair of transistors $(Q_1, Q_2,$ Figure 5; $R_3, Q_4,$ Figure 7) for supplying a hold current, characterised in that the memory cells have respective transistor emitter regions $(E_1, E_m)$ of different areas such that the hold currents of the different memory cells are substantially uniform regardless of the positions of the memory cells along the word lines.

2. A semiconductor memory according to claim 1, characterised in that the areas of the emitter regions differ from memory cell to memory cell along its word lines.

3. A semiconductor memory according to claim 1, characterised in that the areas of the emitter regions differ from one group of memory cells to the next group of memory cells along the word lines.

4. A semiconductor memory according to claim 1, characterised in that the memory cell includes first and second resistors $(r_1; r_2)$ which are connected to a first of the word lines (W+), the collectors of the first and second of the pair of transistors $(Q_1, Q_2,)$ being respectively connected to the other ends of the first and second resistors, the emitters of the first and second transistors being commonly connected to the second word line (W-), the base of the first transistor being connected to the collector of the second transistor, and the base of the second transistor being connected to the collector of the first transistor.

5. A semiconductor memory according to claim 1, characterised in that the memory cells are of the integrated injection logic type and the said pair of transistors $(Q_3, Q_4,$ Figure 7) are of a first conduction type and have a common emitter forming an injector connected to a first of the word lines, each memory cell further including third and fourth transistors $(Q_5, Q_6)$ of a second conduction type each of which has a collector $(N_1 \ N_2)$ connected to a respective collector $(P_3 \ P_2)$ of the first and second transistors $(Q_3, Q_4)$, the base of the third transistor $(Q_5)$ being connected to the collector of the fourth transistor $(Q_6)$, the base of the fourth transistor being connected to the collector of the third transistor, and the first and second transistors having bases which are connected to the emitter of the third and fourth transistors and to a second of the word lines.

# Fig. 1

# Fig. 2

## Fig. 3

## Fig. 4

# Fig. 5

# Fig. 6

## Fig. 7A

CEL 1a  W+  CEL ma  CEL na

E1a    Ema    E na

$\sum_{k=1}^{n} i_k$

## Fig. 7B

C5

Q5

B

Q3    Q4

B    E 1a

Q6

C    C6    W+

## Fig. 7C

N1    N2

P2    P1    P3

Q6  Q3    Q4  NEpi   W-

NT    Q5

## Fig. 8

EMITTER AREA

1  2  3    n-1  n

MEMORY CELL POSITION

## Fig. 9

## Fig. 10

## Fig. II A    Fig. II B

| | DOCUMENTS CONSIDERED TO BE RELEVANT | | CLASSIFICATION OF THE APPLICATION (Int. Cl.) |
|---|---|---|---|
| Category | Citation of document with indication, where appropriate, of relevant passages | Relevant to claim | |
| | IEEE JOURNAL OF SOLID-STATE CIRCUITS, vol.SC-6, no. 5, October 1971, New York, US, WIEDMANN & BERGER: "Small size low power bipolar memory cell", pages 283-288 <br><br> * Page 285, paragraph "B-principal layout"; figures 2,3 * <br><br> -- | 1,5 | G 11 C 11/40 <br> H 01 L 27/06 <br> G 11 C 11/34 |
| | IEEE JOURNAL OF SOLID-STATE CIRCUITS, vol.SC-5, no. 5, October 1970, New York, US, BARRETT et al.: "Design considerations for a high-speed bipolar ROM", pages 196-202 <br><br> * Pages 198,199, paragraph "Memory cell array"; figures 4-6 * <br><br> -- | 1 | TECHNICAL FIELDS SEARCHED (Int.Cl.) <br><br> G 11 C 11/40 <br> 11/34 <br> 17/00 <br> H 01 L 27/06 |
| | US - A - 3 747 078 (IBM) <br><br> -- | 1 | |
| P | IEEE TRANSACTIONS ON ELECTRON DEVICES, vol.ED 26, no. 6, June '79 New York, US, KAWARADA et al.: "A 4K-bit static I2L memory", pages 886-892 <br><br> * Page 888, paragraph "C-cell-array construction"; figure 5 * <br><br> -- | 1,3,5 | CATEGORY OF CITED DOCUMENTS <br><br> X: particularly relevant <br> A: technological background <br> O: non-written disclosure <br> P: intermediate document <br> T: theory or principle underlying the invention <br> E: conflicting application <br> D: document cited in the application <br> L: citation for other reasons |
| E | EP - A - 0 005 601 (NIPPON TELEGRAPH)(28-11-1979) <br><br> -- | 1,5 | |
| X | The present search report has been drawn up for all claims | | &: member of the same patent family, corresponding document |

| Place of search | Date of completion of the search | Examiner |
|---|---|---|
| The Hague | 14-02-1980 | SCHMIDT |

EPO Form 1503.1 06.78

## European Patent Office

## EUROPEAN SEARCH REPORT

| DOCUMENTS CONSIDERED TO BE RELEVANT | | | CLASSIFICATION OF THE APPLICATION (Int. Cl. ³) |
|---|---|---|---|
| Category | Citation of document with indication, where appropriate, of relevant passages | Relevant to claim | |
| A | IBM TECHNICAL DISCLOSURE BULLETIN, vol. 12, no. 1, June 1969, Armonk, US, MOORE: "Monolithic drive line terminator", page 67 -- | 1 | |
| A | US - A - 4 122 542 (PHILIPS) -- | 5 | |
| A | IEEE JOURNAL OF SOLID-STATE CIRCUITS, vol.SC-2, no. 4, December 1967, New York, US, IWERSEN et al.: "Beam-lead sealed junction semi-conductor memory with minimal cell complexity", pages 196-201 * Figure 4 * ---- | 1 | TECHNICAL FIELDS SEARCHED (Int. Cl. ³) |